(19) Europäisches Patentamt / European Patent Office / Office européen des brevets

(11) **EP 3 267 462 B1**

(12) **FASCICULE DE BREVET EUROPEEN**

(45) Date de publication et mention de la délivrance du brevet:
**09.12.2020 Bulletin 2020/50**

(51) Int Cl.:
***H01H 89/06*** *(2006.01)*     ***G01R 15/16*** *(2006.01)*

(21) Numéro de dépôt: **17180204.4**

(22) Date de dépôt: **07.07.2017**

(54) **MODULE D'INTERCONNEXION D'UN DISJONCTEUR ET D'UN CONTACTEUR POUR UN ENSEMBLE ÉLECTRIQUE**

VERBINDUNGSMODUL EINES SCHUTZSCHALTERS UND EINES KONTAKTSCHALTERS FÜR EINE ELEKTRISCHE EINHEIT

INTERCONNECT MODULE OF A CIRCUIT BREAKER AND OF A CONTACTOR FOR AN ELECTRICAL ASSEMBLY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **08.07.2016 FR 1656573**

(43) Date de publication de la demande:
**10.01.2018 Bulletin 2018/02**

(73) Titulaire: **Schneider Electric Industries SAS**
**92500 Rueil-Malmaison (FR)**

(72) Inventeurs:
• **COMTOIS, Patrick**
**38050 Grenoble Cedex 09 (FR)**
• **BAURAND, Gilles**
**38050 Grenoble Cedex 09 (FR)**

(74) Mandataire: **Lavoix**
**62, rue de Bonnel**
**69448 Lyon Cedex 03 (FR)**

(56) Documents cités:
| | |
|---|---|
| DE-A1- 4 335 965 | DE-C1- 10 023 966 |
| FR-A1- 3 026 488 | US-A1- 2004 246 661 |
| US-A1- 2005 122 117 | US-A1- 2013 229 192 |
| US-A1- 2014 124 262 | |

EP 3 267 462 B1

**Description**

L'invention concerne un module d'interconnexion entre un disjoncteur et un contacteur pour un ensemble électrique. L'invention concerne également un dispositif électrique pourvu d'un tel module d'interconnexion et d'un contacteur. L'invention concerne enfin un ensemble électrique comportant un disjoncteur et un contacteur électrique raccordés électriquement entre eux au moyen d'un tel module d'interconnexion.

On connait des ensembles électriques destinés à commander l'alimentation électrique d'une charge électrique et d'assurer une protection de cette charge électrique. Par exemple, on connaît des ensembles de départ moteur pour piloter des moteurs électriques industriels, tels que des moteurs asynchrones.

Un tel ensemble électrique comporte typiquement, pour chaque charge électrique, un disjoncteur et un contacteur qui commandent l'alimentation électrique de cette charge électrique. Le disjoncteur, placé en amont, assure une protection de l'alimentation électrique contre des anomalies, telles que des court-circuits ou des surintensités. Le contacteur, placé en aval, permet d'interrompre sélectivement l'alimentation de la charge électrique, en réponse à un signal de commande. Le module d'interconnexion raccorde électriquement entre eux une sortie de puissance du disjoncteur avec une entrée de puissance du contacteur. Un tel module d'interconnexion est par exemple décrit dans FR 2806525 A1.

Lorsque plusieurs charges électriques sont utilisées, il est d'usage de mettre en œuvre plusieurs ensembles de départ moteur connectés entre eux en parallèle, chacun alimentant électriquement une charge. Ces ensembles électriques peuvent être interconnectés entre eux au moyen d'un bus de données, qui permet d'échanger de l'information entre chacun des ensembles électriques et une unité centrale de commande. Par exemple, ce bus de données permet de transmettre un signal de commande à destination d'un contacteur, ou encore de mesurer l'état de chaque contacteur à un instant donné pour effectuer des diagnostics à distance. Un exemple d'un tel bus de données est décrit dans la demande US 2011/0119507 A1.

Des exemples de dispositifs connus sont décrits dans DE 10023966 C1, US 2004/246661 A1 et US 2013/229192 A1. Le document DE 10023966 C1 divulgue un module d'interconnexion selon le préambule de la revendication 1.

Ces dispositifs connus ne donnent cependant pas entière satisfaction. Ils ne permettent pas d'obtenir une information sur la valeur de courant qui circule à un instant donné entre le disjoncteur et le contacteur d'un tel ensemble électrique, car le bus de données est séparé de la connexion de puissance entre le disjoncteur et le contacteur.

C'est à ces inconvénients qu'entend plus particulièrement remédier l'invention, en proposant un module d'interconnexion entre un disjoncteur et un contacteur pour un ensemble électrique, ce module d'interconnexion permettant de mesurer, de façon fiable et de collecter des informations sur le courant de puissance entre le disjoncteur et le contacteur, en temps réel au cours du fonctionnement de l'ensemble.

A cet effet, l'invention a pour objet un module d'interconnexion entre un disjoncteur électrique et un contacteur électrique conforme à la revendication 1.

Grâce à l'invention, en incorporant un appareil de mesure du courant au sein même du module d'interconnexion, on dispose d'un moyen fiable pour mesurer le courant qui circule au travers des conducteurs de puissance entre le disjoncteur et le contacteur. L'unité électronique de traitement permet de collecter les informations mesurées par l'appareil de mesure et de les transmettre vers le bus de données. Il est ainsi possible de centraliser tous les échanges de données avec le contacteur au niveau du module d'interconnexion et de les transmettre vers une unité de commande de la ligne de départ moteur.

Au contraire, dans l'état de la technique connu, les échanges de données sont réalisés uniquement avec une interface d'échange de données du contacteur, que ce soit pour transmettre un signal de commande ou pour collecter des informations sur l'état du contacteur. Une telle interface est ménagée à l'écart de la connexion de puissance entre le disjoncteur et le contacteur, de sorte qu'il n'est pas possible de mesurer des informations relatives au courant qui circule entre le contacteur et le disjoncteur.

Selon des modes de réalisation avantageux mais non obligatoires de l'invention, le module d'interconnexion peut comporter l'une ou l'autre des caractéristiques suivantes, prises selon toute combinaison techniquement admissible, dans lesquelles :

- L'appareil de mesure du courant comprend des capteurs de courant de type Rogowski, chacun monté autour d'un des conducteurs électriques de puissance pour mesurer l'intensité du courant électrique qui circule dans ce conducteur électrique de puissance.
- Le capteur de tension comporte au moins une plaque électriquement conductrice disposée à distance et en face d'un des conducteurs électriques de puissance, la tension électrique étant détectée en fonction de la valeur de la capacité électrique entre la plaque électriquement conductrice et le conducteur électrique de puissance correspondant.
- Le module comporte une liaison de données apte à être raccordée à un circuit de commande du contacteur, l'unité électronique de traitement étant en outre programmée pour délivrer un signal de commande à destination du contacteur par l'intermédiaire de cette interface.
- Le module comporte une plaque de séparation logée à l'intérieur du boîtier et comprenant une zone au moins partiellement surmoulée sur les conducteurs électriques de puissance.

- La carte électronique est fixée à la plaque de séparation.

Selon un autre aspect, l'invention concerne un dispositif électrique, comportant :

- un contacteur électrique, comportant des contacts électriques séparables adaptés pour sélectivement raccorder ou isoler électriquement l'une de l'autre des entrées et des sorties de courant du contacteur en réponse à un signal de commande,
- un module d'interconnexion, comportant des conducteurs électriques de puissance raccordés électriquement aux entrées de courant du contacteur électrique et étant adapté pour raccorder électriquement ce contacteur électrique à un disjoncteur électrique.

Conformément à l'invention, le module d'interconnexion est tel que décrit ci-dessus, les conducteurs électriques de puissance du module d'interconnexion étant raccordés électriquement aux entrées de courant du contacteur.

Selon des modes de réalisation avantageux mais non obligatoires de l'invention, le dispositif électrique peut comporter la caractéristique suivante :

- le module d'interconnexion est tel que décrit ci-dessus et la liaison de données est connectée à une interface correspondante du contacteur électrique pour commuter le déplacement des contacts séparables du contacteur entre des états ouvert et fermé.

Selon encore un autre aspect, l'invention concerne un ensemble électrique, comportant un disjoncteur électrique et un dispositif électrique, comportant un contacteur électrique et un module d'interconnexion raccordé au contacteur, dans lequel le module d'interconnexion est agencé entre le disjoncteur et le contacteur, et raccordant électriquement le disjoncteur au contacteur. Conformément à l'invention, le dispositif électrique est conforme ce qui est décrit précédemment.

L'invention sera mieux comprise et d'autres avantages de celle-ci apparaîtront plus clairement à la lumière de la description qui va suivre, d'un mode de réalisation d'un module d'interconnexion, donné uniquement à titre d'exemple et faite en référence aux dessins annexés dans lesquels:

- la figure 1 est une représentation schématique d'une installation électrique comportant un ensemble électrique pourvu d'un module d'interconnexion selon l'invention ;
- la figure 2 représente schématiquement, selon une vue en perspective éclatée, un ensemble électrique de la figure 1 comportant un disjoncteur, un contacteur et un module d'interconnexion selon l'invention ;
- les figures 3 et 4 représentent schématiquement le module d'interconnexion des figures 1 et 2, respectivement dans une configuration assemblée et dans une vue éclatée ;
- les figures 5 et 6 représentent schématiquement, selon, respectivement, une vue de dessus et de dessous, une carte électronique du module d'interconnexion de la figure 2;
- la figure 7 représente schématiquement, selon une vue rapprochée, des conducteurs électriques de puissance du module d'interconnexion de la figure 2 ;
- la figure 8 est une vue schématique en coupe longitudinale de la carte électronique des figures 5 et 6 ;
- les figures 9 et 10 représentent schématiquement, selon des vues en perspective, un appareil de mesure du courant circulant au travers des conducteurs électriques de puissance de la figure 7 ;
- la figure 11 représente schématiquement, selon une vue éclatée, l'appareil de mesure de courant des figures 9 et 10 ;
- la figure 12 représente schématiquement un autre mode de réalisation de l'appareil de mesure de courant des figures 8 à 10 ;
- la figure 13 représente schématiquement, selon une vue en coupe, un capteur de tension électrique équipant le module d'interconnexion de la figure 2 ;
- la figure 14 représente schématiquement un schéma électrique du capteur de tension de la figure 10.
- les figures 15 et 16 représentent schématiquement deux modes de réalisation d'une liaison de données entre le module d'interconnexion et le contacteur de la figure 2.

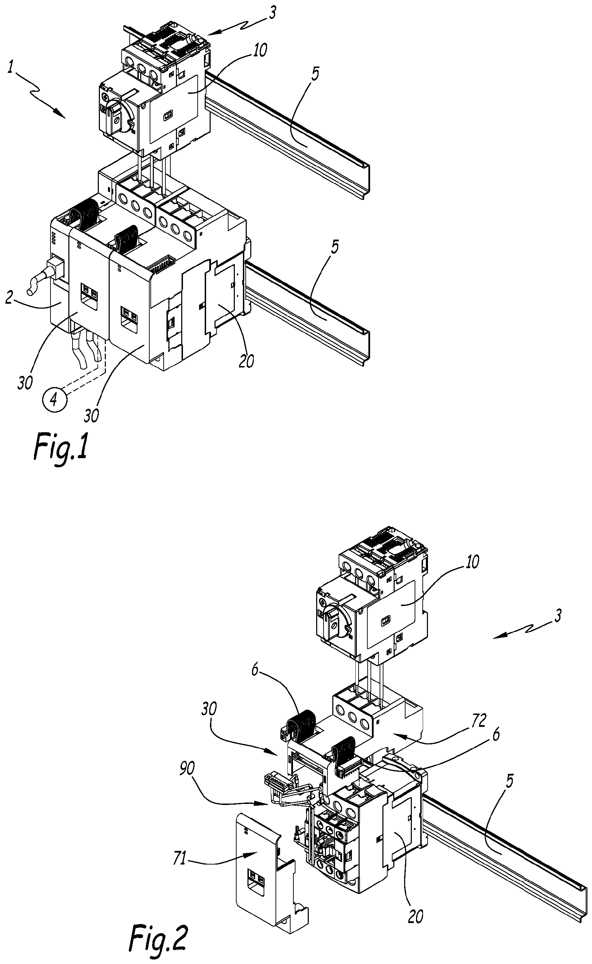

La figure 1 représente une installation électrique 1 de commande d'un ensemble de charges électriques. Cette installation électrique 1 comporte une unité centrale de commande 2, aussi nommée tête de ligne, et plusieurs ensembles électriques 3, chacun apte à commander l'alimentation électrique d'une charge électrique 4. L'unité centrale 2 et les ensembles électriques 3 sont fixés le long d'un ou plusieurs rails de fixation 5, par exemple de type connu sous le nom « rail DIN ». Ces ensembles électriques 3 sont ici identiques entre eux.

Dans cet exemple, les charges électriques 4 sont des moteurs électriques industriels, tels que des moteurs asynchrones.

Pour simplifier la figure 1, seuls deux ensembles électriques 3 sont illustrés. En variante, l'ensemble 1 peut comporter un nombre différent de tels ensembles électriques 3. De même, seul un unique moteur 4 est illustré.

Chacun des ensembles électriques 3 est adapté pour commander l'alimentation électrique d'une charge électrique 4. Plus précisément, chacun des ensembles électriques 3 est intercalé entre une source d'énergie électrique, non illustrée, et une des charges électriques 4. Les ensembles électriques 3 sont ainsi adaptés pour à réguler l'alimentation électrique de cette charge électrique 4, par exemple pour activer ou désactiver sélectivement l'alimentation de la charge électrique correspondante 4. Dans cet exemple, la source d'énergie électrique fournit un courant électrique d'alimentation, ici alternatif et triphasé.

Comme illustré à la figure 2, chacun des ensembles électriques 3 comporte un disjoncteur 10, un contacteur 20 et un module d'interconnexion 30 entre le disjoncteur 10 et le contacteur 20.

Le disjoncteur 10 est adapté pour interrompre, en cas d'anomalie ou d'un défaut de sécurité, la circulation du courant électrique en provenance de la source d'alimentation. Ce défaut est par exemple une surintensité ou un court-circuit.

Le disjoncteur 10 est ici un disjoncteur multipolaire, pourvu d'une pluralité de pôles électriques, chacun associé à une phase électrique du courant électrique d'alimentation. Par exemple, le disjoncteur 10 comporte, pour chaque pôle, une entrée et une sortie de courant raccordée entre elles par des contacts électriques séparables internes au disjoncteur 10. Ces contacts électriques sont commutables entre des états ouvert ou fermé, de manière à, respectivement, interrompre ou autoriser le passage d'un courant entre l'entrée et la sortie de courant. Cette commutation est réalisée automatiquement, par un circuit de détection d'un défaut électrique, en cas d'une anomalie telle qu'une surintensité ou un court-circuit.

Les entrées de courant du disjoncteur 10 sont raccordées à la source d'énergie électrique.

Le contacteur 20 est adapté pour interrompre ou, en alternance, autoriser la circulation du courant électrique provenant en sortie du disjoncteur 10, à destination de la charge électrique 4 correspondante, ceci en fonction d'un signal de commande délivré par l'unité centrale 2.

Le contacteur 20 est ici un contacteur multipolaire, pourvu d'une pluralité de pôles électriques, chacun associé à une phase électrique du courant électrique d'alimentation. Par exemple, le disjoncteur 20 comporte, pour chaque pôle, une entrée et une sortie de courant raccordées entre elles par des contacts électriques séparables internes au contacteur 20. Ces contacts électriques sont sélectivement déplaçables entre des positions ouverte et fermée, dans lesquelles ils inhibent ou, respectivement, autorisent la circulation d'un courant électrique entre l'entrée et la sortie de courant du contacteur 20. Ce déplacement est réalisé au moyen d'un actionneur interne au contacteur 20, en réponse au signal de commande. Cet actionneur comporte par exemple un électroaimant.

Le contacteur 20 comporte également des capteurs de mesure de l'état des contacts électriques séparables. En particulier, ces capteurs sont configurés pour fournir un premier signal d'état indiquant que les contacts sont dans un état normalement fermé, dit signal d'état « NC », pour « normally closed » en langue anglaise. Ces capteurs sont également configurés pour fournir un deuxième signal d'état indiquant que les contacts sont dans un état ouvert, dit signal d'état « NO », pour « normally open » en langue anglaise. Ces signaux d'état permettent d'établir un diagnostic de l'état du contacteur 20.

Les sorties de courant du contacteur 20 sont raccordées électriquement à la charge électrique 4 correspondante pour alimenter cette charge électrique 4 avec le courant électrique d'alimentation.

L'unité centrale 2 est notamment configurée pour commander sélectivement chacun des contacteurs 20 et pour collecter des informations sur l'état de chacun des contacteurs 20 fourni par chacun de ces contacteurs 20. A cet effet, l'installation 1 comporte un bus de données qui raccorde les différents ensembles électriques 3 à l'unité centrale 2. Ce bus de données est ici réalisé en connectant les ensembles électriques 3 en série, ici deux à deux, au moyen de nappes 6 de câbles, comme expliqué plus en détail dans ce qui suit.

Le module d'interconnexion 30 relie électriquement les sorties de courant du disjoncteur 10 aux entrées de courant correspondantes du contacteur 20. En outre, le module d'interconnexion 30 est apte à mesurer des grandeurs physiques représentatives du courant électrique qui circule du disjoncteur 10 vers le contacteur 20, comme expliqué plus en détail dans ce qui suit. Le module 30 est ici destiné à être placé au-dessus du contacteur 20 et en-dessous du disjoncteur 10.

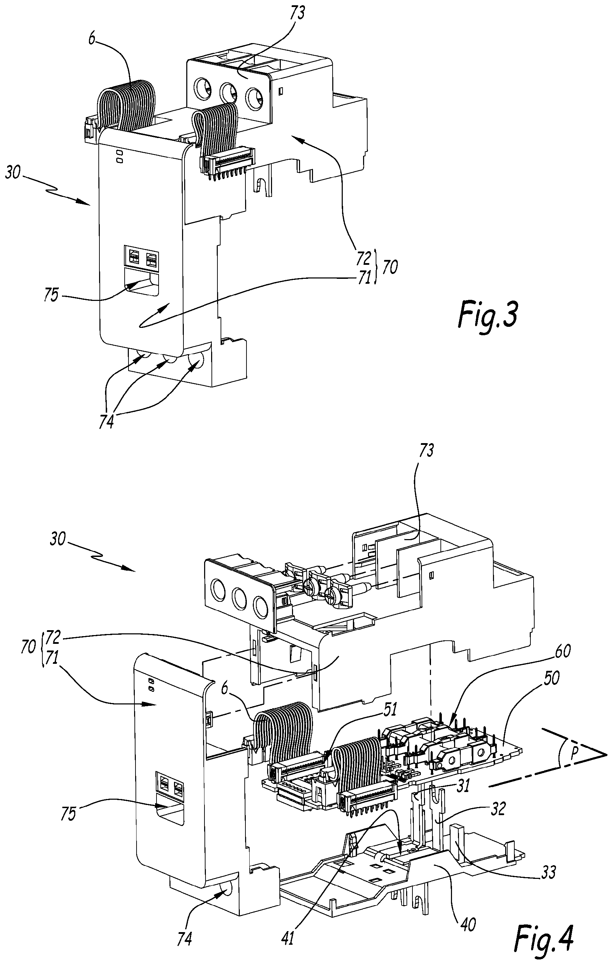

Les figures 3 à 6 représentent plus en détail un exemple du module d'interconnexion 30. Le module d'interconnexion 30 comporte notamment des conducteurs électriques de puissance 31, 32 et 33, une plaque de support 40, une carte électronique 50 et un boîtier 70. Le module d'interconnexion 30 comporte en outre un appareil de mesure du courant 60, un capteur de tension 80 et une liaison de données 90, dont le rôle respectif est décrit plus en détail dans ce qui suit.

Les conducteurs électriques de puissance 31, 32 et 33 sont chacun adaptés pour transporter un courant électrique associé à une phase électrique du courant d'alimentation. Chacun des conducteurs de puissance 31, 32, 33 raccorde électriquement une sortie de courant d'un pôle du disjoncteur 10 à une entrée correspondante de courant du contacteur 20 correspondant à ce même pôle.

Par « conducteur électrique de puissance », on désigne un conducteur électrique apte à conduire des courants électriques d'intensité supérieure ou égale à 10 Ampères, de préférence d'intensité supérieure ou égale à 100 Ampères. Par comparaison, l'intensité des courants électriques qui circulent dans les nappes de câbles 6 du bus de données est au moins dix fois inférieure ou cent fois inférieure aux intensités des courants électriques d'alimentation.

Les conducteurs électriques 31, 32 et 33 sont ici réalisés en un matériau électriquement conducteur, tel que du cuivre.

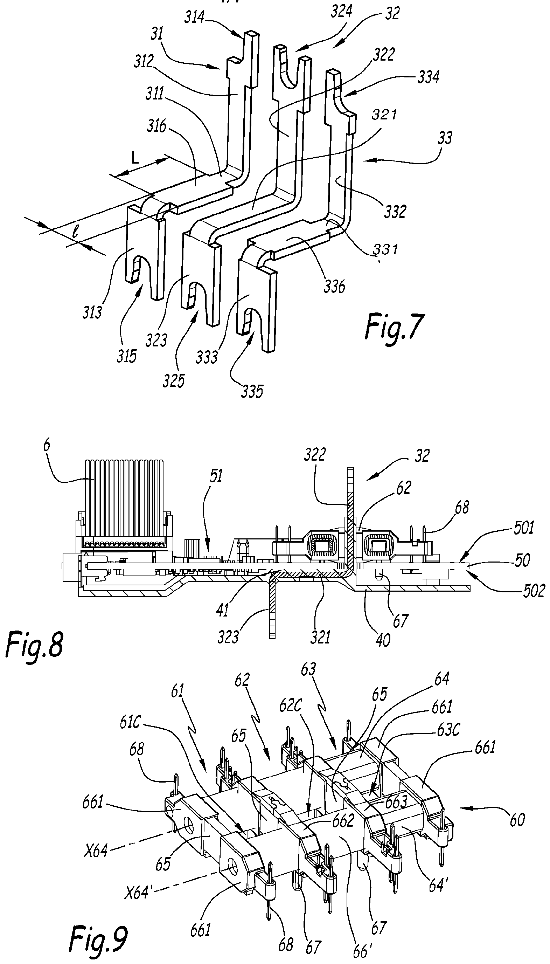

Comme illustré à la figure 7, chacun des conducteurs électriques 31, 32, 33 comporte une partie centrale plane et des parties supérieure et inférieure. La partie centrale présente une forme de plaque plane. Les parties supérieure et inférieure s'étendent en saillie perpendiculairement par rapport à la plaque plane, depuis des extrémités opposées de la partie centrale. Ces parties supérieure et inférieure s'étendent de part et d'autre de la partie centrale parallèlement entre elles.

On note 311, 321 et 331 les parties centrales, respectivement, des conducteurs électriques 31, 32, 33. On note également 312, 322 et 332 les parties supérieures des conducteurs électriques 31, 32, 33 et on note 313, 323 et 333 les parties inférieures des conducteurs électriques 31, 32, 33.

Dans une configuration montée du module 30, les parties centrales 311, 321 et 331 s'étendent parallèlement à un plan géométrique P.

Chaque partie supérieure 312, 322 et 332 est terminée par une zone de raccordement 314, 324, 334 pourvue d'un trou de vissage adapté pour recevoir une vis de connexion, de manière à former une liaison électrique avec un autre connecteur électrique pour raccorder ce conducteur de puissance à une sortie de courant du disjoncteur 10.

De façon analogue, chaque partie inférieure 313, 323, 333 est terminée par une zone de raccordement pourvue d'un trou de vissage 315, 325, 335 adapté pour recevoir une vis de connexion, de manière à former une liaison électrique avec un autre connecteur électrique pour raccorder ce conducteur de puissance à une sortie de courant du contacteur 20.

Dans une configuration montée du module 30, les conducteurs électriques 31, 32 et 33 sont alignés entre eux, de manière à ce que leurs parties supérieures 312, 322 et 332 soient parallèles entre elles et que leurs parties inférieures 313, 323, 333 soient parallèles entre elles. Le conducteur électriques 32 est disposé entre les conducteurs électriques 31 et 33.

Dans cet exemple, les conducteurs de puissance 31, 32 et 33 présentent une forme similaire, de sorte que seules leurs différences sont décrites en détail dans ce qui suit.

Avantageusement, les conducteurs électriques 31, 32 et 33 diffèrent par la forme spécifique de la zone de raccordement 314, 324, 334 et/ou des zones de raccordement 315, 325, 335. Cela facilite le repérage visuel des différents pôles et joue une fonction de détrompage qui évite à un opérateur, lors d'opérations de montage du module d'interconnexion 30, de permuter la position des conducteurs électriques 31, 32 et 33.

Les conducteurs électriques 31, 32 et 33 diffèrent également les uns des autres par la dimension de leur partie centrale 311, 321, 331.

En particulier, les conducteurs électriques 31 et 33 sont pourvus d'une surlargeur au niveau de leur partie centrale, respectivement, 311 et 331. Cette surlargeur prend la forme d'une plaque, respectivement notée 316 et 336, intégrée au sein de la partie centrale, respectivement 311 et 331.

Les plaques 316 et 336 sont ici identiques et présentent une forme rectangulaire, de largeur « L » et de longueur « l ». A titre d'exemple illustratif, la largeur L est ici égale à 12mm et la longueur l est ici égale à 6mm. La largeur L et la longueur l sont mesurées parallèlement au plan géométrique P dans la configuration montée du module 30.

La plaque de support 40 présente une forme essentiellement plane s'étendant selon le plan P. Cette plaque de support 40 est réalisée dans un matériau rigide et électriquement isolant, par exemple en matière plastique, telle que du polyamide 6-6.

La plaque de support 40 comporte une zone surmoulée 41 sur les parties centrales 311, 321 et 331 des conducteurs électriques 31, 32 et 33, de part et d'autre des faces opposées de ces parties centrales 311, 321, 331. Ces zones surmoulées 41 permettent d'isoler électriquement les conducteurs électriques 31, 32 et 33 partiellement par rapport à la carte électronique 50. Les zones surmoulées 41 présentent des dimensions correspondantes à la largeur de la partie centrale 311, 321, 331, notamment pour tenir compte des plaques 316 et 336 ménagées au niveau des parties centrales 311 et 331.

Les conducteurs électriques 31, 32 et 33 sont donc partiellement intégrés au sein de la plaque de support 40. Les parties supérieures 312, 322 et 332 et les parties inférieures 313, 323 et 333 s'étendent en saillie de part et d'autre de la plaque de support 40, comme illustré à la figure 8.

Ainsi, grâce à la plaque de support 40 et aux zones surmoulées 41, une isolation électrique est assurée entre les conducteurs électriques 31, 32 et 33 et la carte électronique 50.

Dans cet exemple, le module 30 est destiné à être fixé mécaniquement au contacteur 20. Le module 30 comporte par exemple des dispositifs de fixation, non illustrés, pour l'attacher solidairement au boîtier du contacteur 20.

Dans une configuration montée, comme visible à la figure 2, le contacteur 20 et le module d'interconnexion 30 forment ainsi un dispositif électrique. A cet effet, le boîtier 70 du module 30 présente une forme complémentaire à celle du contacteur 20.

Le boîtier 70 présente plus particulièrement, comme illustré à la figure 3, une forme comprenant deux blocs principaux joints entre eux et s'étendant perpendiculairement selon une en forme « en L ». Le boîtier 70 est par exemple réalisé en plastique moulé.

Dans une configuration montée du module 30 sur le contacteur 20, l'une des blocs, dite bloc avant 71, est disposée en contact avec une face avant du contacteur 20. L'autre bloc, dit bloc supérieur 72, est disposé sur une face supérieure du contacteur 20. Les conducteurs électriques 31, 32 et 33, la plaque 40 et la carte électronique 50 sont logés à l'intérieur du bloc supérieur 72.

Le boîtier 70 comporte un corps délimitant un logement creux et un couvercle qui recouvre et ferme le corps. L'assemblage de ce corps et de ce couvercle permet d'obtenir les deux blocs 71 et 72 du boîtier 70.

En variante, la forme du boîtier 70 peut être différente.

Dans une configuration assemblée du module 30, les zones de raccordement 315, 325 et 335 des parties supérieures 312, 322 et 332 s'étendent à l'extérieur du bloc supérieur, ici au travers du couvercle.

Ici, le module 30 comporte un bornier 73 pour faciliter la connexion des zones de raccordement 315, 325 et 335 aux sorties correspondantes de courant du disjoncteur 10. Ce bornier 73 est disposé sur une face supérieure du bloc 72, Le bornier 73 est ici intégré au sein du boîtier 70.

Lorsque le bornier 73 est utilisé, le raccordement électrique entre le module de liaison 30 et le disjoncteur 10 est réalisé au moyen de câbles électriques dédiés, dont des extrémités terminales respectives sont connectées aux conducteurs de puissance, respectivement 31, 32 et 33, par vissage dans le bornier 73. Ainsi, le disjoncteur 10 peut être fixé à une distance éloignée du module de liaison 30, sans devoir impérativement être en contact avec le boîtier 70. Cela permet d'adapter l'utilisation du module 30 à une grande variété de situations, notamment en fonction de l'environnement de l'installation électrique 1.

En variante, le bornier 73 peut être monté de façon amovible par rapport au boîtier 70.

Selon encore une autre variante, le bornier 73 peut être omis. Lorsque le bornier 73 est omis, les zones de raccordement 315, 325 et 335 des conducteurs électriques 31, 32, 33 sont directement accessibles depuis à l'extérieur du boîtier 70. De cette façon, le disjoncteur 10 peut être fixé au module de liaison 30 directement par simple embrochage. Le disjoncteur 10 est alors en contact avec le module 30. Dans ce cas, le module 30 raccorde donc mécaniquement le disjoncteur 10 au contacteur 20.

Avantageusement, la partie avant 71 est pourvue de trous traversants 74. Ces trous 74 sont agencés de sorte à déboucher en face de trous correspondants ménagés sur le contacteur 20 lorsque le module 30 est monté sur le contacteur 20. Ces trous permettent à un utilisateur de faire passer un tournevis au travers du module 30, de manière à accéder à des vis de serrage du contacteur 20. Ces vis de serrage sont utilisés pour connecter des câbles électriques aux sorties de courant du contacteur 20 pour le raccorder à la charge électrique 4 correspondante. Grâce à cela, le module 30 peut être utilisé sur des contacteurs 20 existants, sans avoir à modifier la géométrie ou l'architecture de ces contacteurs 20.

De façon optionnelle, la partie avant 71 est pourvue d'une fenêtre traversante 75. La fenêtre 75 est agencée de sorte à déboucher en face d'une fenêtre préexistante du contacteur 20 lorsque le module 30 est monté sur la contacteur 20. En effet, le contacteur 20 comporte une fenêtre, ici non illustrée, qui indique la position des contacts électriques séparables et qui peut être utilisée par un utilisateur pour vérifier, de façon mécanique, la position des contacts électriques séparables. Là encore, le module 30 peut être monté sur des contacteurs 20 existants, sans avoir à modifier la géométrie ou l'architecture de ces contacteurs 20.

En variante, les trous 74 et/ou la fenêtre 75 sont omis.

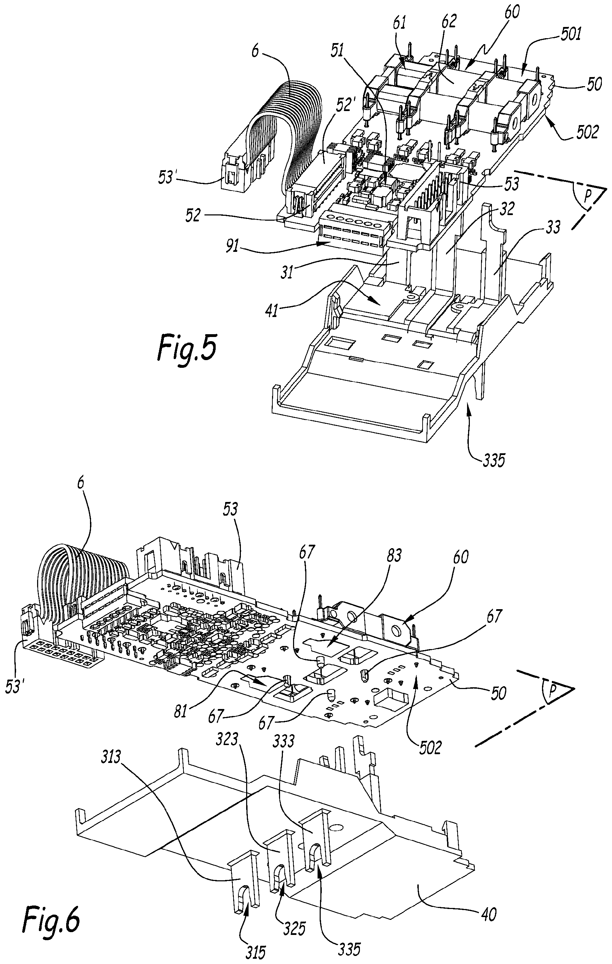

Les figures 5, 6 et 8 représentent plus en détail la carte électronique 50. La carte électronique est pourvue d'un circuit électronique incluant notamment une unité électronique 51, dont le rôle et la fonction sont décrits dans ce qui suit. Par exemple, l'unité électronique 51 est un microcontrôleur programmable.

La carte électronique 50 comporte ici un circuit imprimé, réalisé sur un support rigide isolant, au moyen de pistes électriquement conductrices. Le support isolant est par exemple une plaque en résine époxy de type PCB-A pour « Printed Circuit Board » en langue anglaise.

On note « 501 » la face supérieure de la carte électronique 50 et « 502 » une face inférieure de la carte électronique 50, opposée à la face 501.

Dans cet exemple, les composants électroniques appartenant au circuit électronique de la carte électronique 50 sont ménagés sur la face supérieure 501. Les pistes électriquement conductrices formant les circuits imprimés sont ménagées sur la face inférieure 502 opposée.

Dans une configuration assemblée du module 30, la carte électronique 50 est disposée parallèlement à la plaque de support 40 et donc parallèlement au plan géométrique P. Ici, la carte électronique 50 est au moins partiellement en contact avec la plaque 40.

La carte électronique 50 est pourvue de plusieurs orifices traversants, dits orifices de passage, permettant le passage des parties supérieures 312, 322 et 332 des conducteurs électriques 31, 32 et 33. De cette manière, lorsque le module 30 est dans une configuration assemblée, chacun des conducteurs électriques 31, 32 et 33 traverse la carte électronique 50. Les parties supérieures 312, 322 et 332 s'étendent alors perpendiculairement à cette carte électronique 50.

En variante, la carte électronique 50 est disposée sous les parties centrales 311, 321, 331, de manière à être traversée par les parties inférieures 313, 323 et 333 des conducteurs électriques 31, 32 et 33. Dans ce cas, les faces 501 et 502 sont permutées.

L'unité électronique 51 comporte une interface de raccordement apte à être connectée avec le bus de données. La carte électronique 50 comporte à cet effet des connecteurs 52 et 53 fixés sur la face supérieure 501 et connectés aux pistes électriquement conductrices du circuit intégré. Ces connecteurs 52 et 53 sont configurés pour être raccordés à des connecteurs correspondants, notés respectivement 52' et 53' de la nappe 6. Par exemple, les connecteurs 52' et 53' sont ménagés à des extrémités opposés d'une nappe de câbles électriques souples. Les connecteurs 52 et 53 sont ici de type différent et notamment de taille différente, de manière à éviter toute permutation non souhaitée des nappes de câbles 6 formant le bus de données. Dans cet exemple, le connecteur 53 est accessible depuis l'extérieur du boîtier 70 du module 30.

Le bus de données autorise l'échange de données entre le module 30 et l'extérieur de l'ensemble 3. Ces données sont par exemple des signaux de commande de l'actionneur du contacteur 20 ou des signaux indiquant l'état du contacteur 20. Le bus de données achemine également une alimentation électrique de la carte électronique 50, par exemple au moyen d'une tension électrique inférieure ou égale à 24V DC.

Dans cet exemple, dans une configuration montée du module 30, un exemplaire de la nappe de câbles 6 est connecté à la carte électronique 50 par l'intermédiaire du connecteur 52', ce dernier étant reçu à l'intérieur du connecteur 52 correspondant. Cette connexion est par exemple réalisée lors d'opérations de fabrication du module 30, préalablement à la fermeture du boîtier 70, de telle sorte que l'extrémité de la nappe 6 comportant le connecteur 53' dépasse à l'extérieur du boîtier 70. Le connecteur 53' peut alors être connecté électriquement à un connecteur 53 correspondant du module 30 d'un autre ensemble 3 de l'installation 1 ou encore à l'unité centrale 2.

Le module 30 comporte en outre un appareil de mesure de courant 60, illustré plus en détail aux figures 9, 10 et 11.

L'appareil de mesure 60 est configuré pour mesurer les valeurs des courants électriques qui circulent dans les conducteurs électriques 31, 32 et 33. L'appareil de mesure 60 comporte à cet effet plusieurs capteurs de courant 61, 62, 63 de type Rogowski, chacun adapté pour mesurer les valeurs d'intensité du courant électrique qui circule, respectivement, dans un des conducteurs électriques 31, 32 et 33. De tels capteurs de type Rogowski permettent de déterminer la valeur du courant qui circule au sein d'un conducteur électrique, en mesurant le flux magnétique induit autour de ce conducteur électrique par la circulation du courant électrique en son sein.

Les capteurs de courant 61, 62 et 63 sont ici adjacents deux à deux et alignés de façon rectiligne. Chacun des capteurs de courant 61, 62 et 63 comporte des bobines 64 et 64', ou solénoïdes, ici identiques, et une zone centrale de réception 61C, 62C, 63C du conducteur électrique 31, 32 et 33 correspondant. L'appareil de mesure 60 est ici fixé sur la face supérieure 501 de la carte électronique 50.

Dans une configuration assemblée du module de liaison 30, chacun des conducteurs électriques 31, 32 et 33 est reçu à l'intérieur de l'ouverture centrale 61C, 62C et 63C, respectivement, des capteurs de courant 61, 62 et 63. Ainsi, l'appareil de mesure 60 permet de mesurer, en temps réel, la valeur de l'intensité des courants électriques qui circulent au sein des conducteurs électriques 31, 32, 33 entre le disjoncteur 10 et le contacteur 20.

Les bobines 64 et 64' sont aptes à être raccordées électriquement entre elles pour former un circuit de mesure du courant dans le conducteur correspondant. Les bobines 64 et 64' sont rectilignes et s'étendent le long d'axes longitudinaux, respectivement notés X64 et X64'. Chaque bobine 64, 64' comporte ici un solénoïde formé par enroulement d'un fil conducteur avec un nombre de spires compris, à titre illustratif, de 520 spires réparties sur cinq couches avec une valeur d'inductance de 0,7mH pour chacune des bobines 64, 64'.

L'appareil de mesure 60 comporte en outre plusieurs barreaux ferromagnétiques 65, ici identiques entre eux, et des première et deuxième armatures, ou carcasses, notées respectivement 66 et 66', sur lesquelles sont ménagées les bobines 64 et 64'. Dans cet exemple, les armatures 66 et 66' sont disposées parallèlement entre elles et sont communes à tous les capteurs de courant 61, 62 et 63 de l'appareil de mesure 60.

Les barreaux magnétiques 65 permettent de canaliser le flux magnétique généré lors du passage d'un courant électrique dans le conducteur électrique 31, 32, 33 correspondant, de manière à faciliter sa mesure par les bobines 64 et 64'. Par exemple, les barreaux ferromagnétiques 65 sont réalisés en un alliage de fer, tel que du fer doux ou du nickel fer NiFe ou un alliage FeSi. Les barreaux ferromagnétiques 65 sont ici au nombre de quatre.

Ainsi, lorsqu'un courant électrique circule au travers des conducteurs électriques 31, 32 et 33, il apparaît flux magnétique qui engendre une différence de potentiel électrique aux bornes des bobines 64 et 64' des capteurs de courants correspondants 61, 62 et 63. Ces différences de potentiel électrique sont mesurées par l'unité électronique 51, par exemple au moyen d'un convertisseur analogique-numérique, non illustré. L'unité électronique 51 en déduit alors automatiquement la valeur de l'intensité électrique correspondante pour chacun des conducteurs électriques 31, 32 et 33, par exemple à partir d'une formule prédéterminée.

Les capteurs de courant 61, 62 et 63 sont ici identiques entre eux, de sorte que seul le capteur de courant 61 est décrit en détail dans ce qui suit, dans la mesure où la description qui en est faite est leur transposable.

Plus précisément, le capteur de courant 61 comporte deux des bobines 64 et 64', disposées parallèlement entre elles et face à face sur des bords opposés de la zone centrale 61C. Le capteur de courant 61 comporte en outre deux des barreaux ferromagnétiques 65. Ces barreaux ferromagnétiques 65 sont disposés dans un même plan avec les bobines 64 et 64' et s'étendent entre les extrémités des bobines 64 et 64' perpendiculairement aux axes X64 et X64'.

Chacun des capteurs de courant 61, 62, 63 présente un barreau ferromagnétique 65 qui est en commun avec le capteur de courant immédiatement voisin. En l'espèce, ici, le capteur de courant 61 présente un barreau 65 en commun avec le capteur de courant 62. De même, le capteur de courant 63 présente un barreau 65 en commun avec le capteur de courant 62.

Ainsi, dans cet exemple, l'appareil de mesure 60 comporte trois bobines 64 et trois bobines 64'. L'appareil de mesure 60 comporte également quatre barreaux ferromagnétiques 65 qui s'étendent entre les bobines 64 et les bobines 64'. Les bobines 64, 64' et les barreaux ferromagnétiques 65 sont arrangés dans un même plan parallèle au plan géométrique P de manière à former, pour ce capteur de courant 61, un contour polygonal, ici de forme carrée. Ce contour polygonal délimite l'ouverture centrale correspondante 61C.

Dans un mode de réalisation préféré de l'invention, les armatures 66 et 66' présentent chacune une forme rectiligne. Les bobines 64 et 64' sont ménagées sur ces armatures 66 et 66' par enroulement. Ainsi, les axes longitudinaux des bobines X64 et X64' sont confondus avec un axe longitudinal des armatures respectivement 66 et 66'. La bobine qui est enroulée autour de l'armature 66 porte la référence 64, tandis que la bobine qui est enroulée autour de l'armature 66' porte la référence 64'.

Dans cet exemple, chacune des armatures 66 et 66' comporte des logements, ou alvéoles configurées pour recevoir une extrémité d'un des barreaux ferromagnétiques 65.

Ces logements sont ici au nombre de quatre. Les logements situés aux extrémités des armatures 66 et 66' portent la référence 661. Les logements situés entre les logements 661 portent les références 661, 662 et 663. En variante, le nombre de tels logements peut être différent, de préférence au moins égal à deux.

Dans cet exemple, les barreaux ferromagnétiques se présentent sous la forme d'une plaque en forme de parallélépipède rectangle. A titre d'illustration, chaque barreau ferromagnétique 65 présente une longueur de quinze millimètres, une largeur de cinq millimètres et une épaisseur de deux millimètres. Les logements 661 présentent une forme complémentaire à celle des extrémités du barreau 65. Les logements 661, 662 et 663 sont ici intégrés au sein des armatures 66 et 66'. De fait, ces logements 661, 662 et 663 permettent ici de délimiter des zones d'enroulement des bobines 64 et 64'.

Avantageusement, les armatures 66 et 66' sont pourvues d'éléments de fixation 664 et 665, destinés à relier de façon solidaire cette armature à l'armature opposée pour former l'appareil de mesure 60. Ces éléments de fixation 664 et 665 permettent en outre de maintenir en position les barreaux ferromagnétiques 65. Dans cet exemple, les éléments de fixation 664 et 665 sont portés par les logements 662 et 663.

Les éléments de fixation 664 et 665 sont ici des éléments emboîtables de forme complémentaire, par exemple de type tenon-mortaise, autorisant un emboîtage par encliquetage. En variante, ils peuvent être réalisés différemment, par exemple au moyen de crochets.

A titre d'illustration, le logement intermédiaire 662 de l'armature 66 porte un élément de fixation de type mâle 664. Le logement 662 de l'armature 66', situé en face du logement 662 dans une configuration assemblée de l'appareil de mesure 60, porte quant à lui un élément de fixation femelle 665.

Les armatures 66 et 66' portent des plots de fixation 67 qui émergent en saillie à l'appareil de mesure 60, perpendiculairement au plan géométrique P lorsque l'appareil de mesure 60 est dans une configuration assemblée sur la carte électronique 50.

Comme illustré à la figure 9, les plots de fixation 67 sont ménagés d'un même côté de l'appareil de mesure 60, plus précisément sur le côté de l'appareil de mesure 60 qui est destiné à venir en contact avec la carte électronique 50. Ces plots de fixation 67 sont destinés à être reçus dans des trous correspondants, ménagés au travers de la carte électronique 50. Cela permet d'une part de fixer l'appareil de mesure 60 sur la carte électronique 50 mais également de faciliter l'alignement de l'appareil de mesure 60 de façon à ce que les ouvertures centrales 61C, 62C et 63C soient situées en face des ouvertures de passage ménagés sur la carte électronique 50 pour le passage des conducteurs électriques 31, 32 et 33.

L'appareil de mesure 60 comporte en outre des plots 68 de connexion des bobines, ici ménagés sur les armatures 66 et 66', sur des extrémités distales des logements 661, 662 et 663. Ces picots de connexion 68 ont pour fonction de raccorder électriquement les extrémités opposées de chacune des bobines 64 et 64' à l'unité de contrôle 51, par l'intermédiaire des pistes électriquement conductrices de la carte électronique 50, avec lesquelles elles sont destinées à être en contact électrique direct. Plus précisément, les extrémités du fil formant l'enroulement de chacune des bobines 64 et 64' sont alors enroulées autour de ce picot 68 de manière à assurer une connexion électrique. Chaque picot de connexion 68 se présente sous la forme d'une tige droite en un matériau électriquement conducteur dont une extrémité est reçue à l'intérieur de la carte électronique 50, de manière à assurer une connexion électrique avec une piste électrique de la carte électronique 50.

La conception modulaire de l'appareil de mesure 60 permet de simplifier sa fabrication industrielle et de réduire son coût unitaire. En effet, les armatures 66 et 66' sont ici identiques entre elles et ne diffèrent l'une de l'autre que par leur position relative au sein de l'appareil de mesure 60. L'appareil de mesure 60 est formé en assemblant tête-bêche les armatures 66 et 66' l'une avec l'autre. Ainsi, l'appareil de mesure 60 peut être fabriqué avec un nombre de pièces réduit.

En outre, en utilisant des barreaux ferromagnétiques 65, on réduit le coût de l'appareil de mesure 60 par rapport à des appareils de mesure de courant existant de type de Rogowski dans lequel tout le pourtour de chaque ouverture centrale est muni d'un enroulement solénoïde ou de bobine. Dans le cas d'espèce, le nombre de bobines 64, 64' nécessaires pour chacun des capteurs de courant 61, 62 et 63 est égal à deux, ce qui est moindre que dans des capteurs de courant de type Rogowswki connus où au moins quatre telles bobines sont nécessaires.

L'appareil de mesure 60 peut être fabriqué industriellement de la façon suivante.

Lors d'une première étape, une armature 66 ou 66' est acquise. Cette armature 66 ou 66' est préalablement pourvue de picots de connexion 68.

Ensuite, lors d'une deuxième étape, des bobines 64 sont formées par enroulement sur des zones d'enroulement de l'armature 66, par exemple au moyen d'une machine d'enroulement automatique. D'abord, le fil conducteur est d'abord enroulé autour d'un des picots de connexion 68, avec un tour, puis est entouré de façon répétée autour d'une première zone d'enroulement de l'armature 66 pour former une première bobine 64. Puis, ce fil est enroulé autour d'un autre picot de connexion de l'armature 66. Le fil est alors coupé puis l'opération est répétée, de façon similaire, pour chacune des zones d'enroulement de l'armature 66. Ainsi, les bobines sont formées de façon simplifiée autour de l'armature 66.

Puis, lors d'une troisième étape l'appareil de mesure 60 est assemblé. Pour ce faire, les armatures 66 et 66' pourvues des bobines 64 et 64' sont réunies, en face l'une de l'autre. Des barreaux ferromagnétiques 65 sont insérés dans chacun des logements 661, 662 et 663 de l'armature 66. Puis l'armature 66 est fixée sur l'armature 66' en insérant l'extrémité opposée de chacun des barreaux ferromagnétiques 65 dans les logements 661, 662 et 663 correspondants de l'armature 66. Les éléments de fixation 664 et 665 sont alors insérés l'un dans l'autre puis fixés par encliquetage de manière solidariser ces armatures 66 et 66'.

L'appareil de mesure 60 est alors prêt à être monté sur la carte électronique 50.

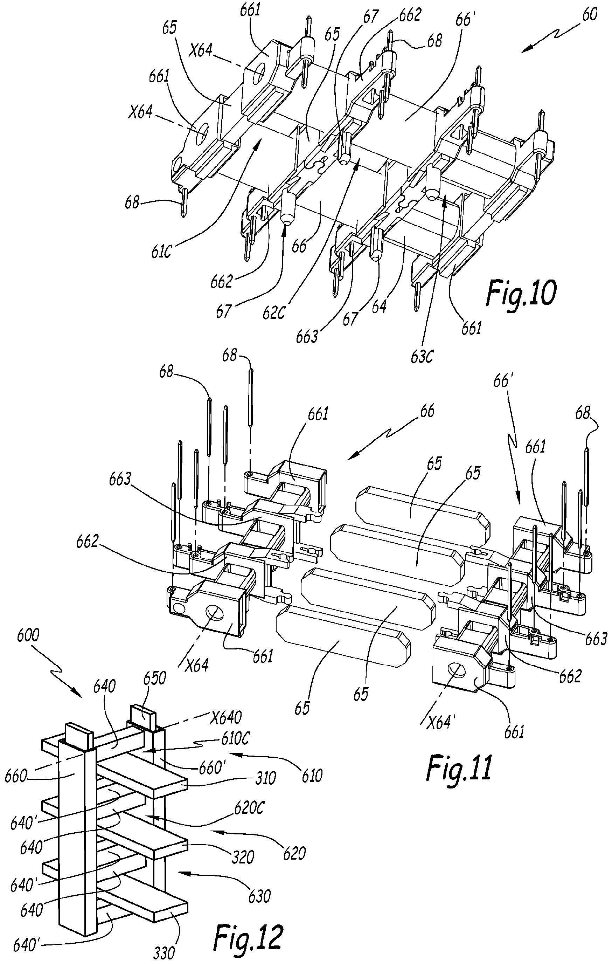

La figure 12 illustre un autre mode de réalisation de l'appareil de mesure 60. On note « 600 » l'appareil de mesure de courant selon ce mode de réalisation. Cet appareil de mesure 600 est particulièrement adapté pour une variante du module de liaison 30, dans lequel les conducteurs électriques 31, 32 et 33 sont remplacés par des conducteurs électriques de puissance 310, 320 et 330 qui sont superposés les uns avec les autres.

Les éléments de cet appareil de mesure 600 qui sont analogues à l'appareil de mesure 60 portent les mêmes références augmentées par un symbole zéro. Par exemple, l'appareil de mesure 600 comporte des barreaux ferromagnétiques qui portent une référence 650 et qui sont similaires aux barreaux ferromagnétiques 65 de l'appareil de mesure 60. Ainsi, ces éléments ne sont pas décrits en détail, dans la mesure où la description ci-dessus peut leur être transposée. Les barreaux 650 sont ici au nombre de deux.

L'appareil de mesure 600 diffère de l'appareil de mesure 60 notamment en ce que les armatures 660 et 660' comportent chacune une partie principale de forme rectiligne et des parties secondaires en forme de branche qui s'étendent en saillie depuis la partie principale perpendiculairement à la partie principale.

Dans cet exemple, les armatures 660 et 660' comportent chacune trois parties secondaires qui s'étendent d'un même côté de la partie principale de sorte à ce que ces armatures présentent une forme en E. Les bobines 84 sont ainsi ménagées sur les parties secondaires en saillie de l'armature 660. Les bobines 640' sont ménagées quant à elles sur les parties secondaires en saillie de l'armature 660'.

Chaque partie principale des armatures 660 et 660' comporte un évidement s'étendant sur toute la longueur de la partie principale et à l'intérieur duquel est reçu un des barreaux ferromagnétiques 650.

Grâce à cette disposition, les armatures 660 et 660' peuvent être assemblées l'une avec l'autre autour des conducteurs électriques 310, 320 et 330.

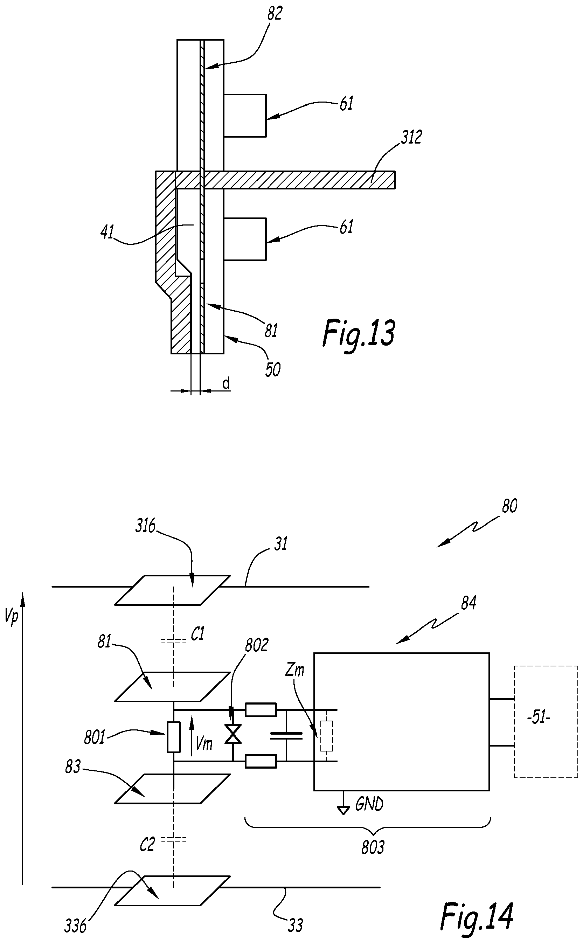

Les figures 13 et 14 représentent plus en détail le capteur de tension 80.

Le capteur de tension 80 a pour but de détecter la présence d'une différence de potentiel électrique entre deux des conducteurs électriques 31, 32 et 33, ici entre les conducteurs électriques 31 et 33. Cela permet indirectement de connaître l'état du disjoncteur 10 et de savoir, notamment, si ce disjoncteur est dans un état ouvert ou fermé. L'unité électronique 51 est en outre configurée pour générer un signal représentatif de l'état du disjoncteur 10 au moyen des données fournies du capteur de tension 80.

Le capteur de tension comporte au moins une plaque électriquement conductrice, ou capteur de champ électrique, ménagée à distance et en regard de l'une des plaques 316, 326 ou 336 des conducteurs électriques 31, 32 et 33, respectivement. La présence ou, alternativement, l'absence d'une tension électrique est déterminée indirectement, en fonction de la valeur de la capacité électrique entre ces plaques au moyen d'un circuit de mesure 84 dédié.

Plus précisément, le détecteur 80 comporte ici deux telles plaques 81 et 83, réalisées en un matériau conducteur et s'étendant parallèlement au plan géométrique P. Dans une configuration assemblée du module 30, la plaque 81 fait face à la plaque 316 en étant alignée avec cette plaque 316. De façon analogue, la plaque 83 fait face à la plaque 336 en étant alignée avec cette plaque 336. Ces plaques 81 et 83 sont formées sur la face 502 de la carte électronique 50, par exemple par dépôt d'une piste métallique en cuivre. Les plaques 81 et 83 présentent des dimensions identiques aux plaques, respectivement, 316 et 336, à 5% près ou préférentiellement à 1% près. Les plaques 81 et 83 ont ici des surfaces, ou superficies, identiques entre elles. Les plaques 81 et 316 sont séparées l'une de l'autre par la partie surmoulée 41 et sont en contact avec cette partie surmoulée 41. Il en va de même avec les plaques 83 et 336, respectivement.

On note « d » la distance entre les plaques 81 et 316, mesurée selon une direction perpendiculaire au plan géométrique P. Cette distance d est égale à l'épaisseur de la partie surmoulée 41 qui recouvre une face supérieure de la plaque 316. La distance d est choisie de manière à rapprocher le plus possible la plaque 81 de la plaque 316, sans pour autant compromettre la fonction d'isolement électrique du conducteur de puissance 31 assurée par la partie surmoulée 41. La distance d est de préférence inférieure ou égale à 2mm, de préférence encore comprise entre 0,5mm et 1mm et, encore plus préférentiellement, comprise entre 0,65mm et 0,85mm. A titre d'illustration, la distance d est ici égale à 0,8mm. Les plaques 83 et 336 sont également distantes l'une de l'autre de la distance d.

On note C1 le condensateur formé par les plaques 81 et 316 et C2 le condensateur formé par les plaques 83 et 336. Les capacités électriques respectives des condensateurs C1 et C2 sont ici égales, compte tenu des dimensions et des dispositions relatives des plaques 81, 83, 316 et 336.

La valeur de la capacité du condensateur C1 est égale à ($\varepsilon$ x S)/d, où S est la superficie des plaques 81 et 316 en regard l'une avec l'autre et « $\varepsilon$ » est la permittivité électrique du matériau formant la partie surmoulée 41. La superficie S est ici égale au produit de la longueur L par la largeur l, dans la mesure où les plaques 81 et 316 sont identiques et face à face l'une avec l'autre. Compte tenu des valeurs numériques indiquées précédemment, la superficie S est ici égale à 74mm$^2$. Dans le cas du polyamide 6-6, le condensateur C1 présente une valeur de capacité comprise entre 2,8pF et 4,4pF lorsque la distance d est comprise entre 0,65mm et 0,85mm. L'homme du métier sait que la valeur de capacité du condensateur C1 est inversement proportionnelle à la distance d.

Le capteur 80 comporte également un circuit de mesure 84, qui inclut les plaques 81 et 83 ainsi qu'une résistance de mesure 801 dont les extrémités sont raccordées d'une part à la plaque 81 et d'autre part à la plaque 83. Le circuit de mesure 84 est adapté pour acquérir une tension de mesure Vm aux bornes de la résistance de mesure 801.

Le circuit de mesure 84 comporte avantageusement une diode Zener bidirectionnelle 802, qui protège le circuit de mesure 84 contre des surtensions, notamment susceptibles de se produire lorsque l'installation électrique 1 ou sa source d'alimentation en énergie électrique est frappée par la foudre.

Le circuit de mesure 83 est raccordé à une entrée de l'unité électronique 51 au moyen d'un convertisseur analogique-numérique, non illustré. Avantageusement, le circuit de mesure 83 comporte également un filtre passe-bas 803 configuré pour laisser passer les fréquences appartenant à l'intervalle 45Hz - 65Hz.

Le filtre 803 permet d'éviter une saturation de l'entrée du convertisseur analogique-numérique, qui pourrait entraîner un dysfonctionnement du capteur 80. Un tel filtre 803 permet notamment de filtrer les harmoniques du courant électrique d'alimentation qui pourraient perturber la mesure du circuit 83. Ici, le courant d'alimentation électrique de l'ensemble 3 présente une fréquence égale à 50Hz ou à 60Hz.

Le capteur 80 comporte enfin un plan de masse électrique 82, ménagé sur la face 502 et relié à une masse électrique GND du circuit de mesure 84, de manière à assurer une protection du dispositif 80 contre des perturbations électromagnétiques. Ce plan de masse 82 est réalisé par dépôt d'une couche métallique sur la face 502, sur une superficie placée en regard de la superficie occupée par le capteur de courant 61.

Dans cet exemple, la détection de présence d'une tension électrique est réalisée par le capteur de tension 80 entre les conducteurs électriques 31 et 33. Lorsqu'une tension électrique Vp est présente entre ces conducteurs électriques 31 et 33, la tension de mesure Vm aux bornes de la résistance 501 est égale à une valeur qui dépend de la tension Vp et de la valeur de capacité des condensateurs C1 et C2. Par exemple, la tension Vm est calculée au moyen de la formule suivante :

$$Vm = \frac{Vp \times (Rm + Zm)}{Zm + C}$$

où « Rm » est la valeur de la résistance de mesure 801, « Zm » est l'impédance de mesure à l'entrée de l'unité électronique 51 et « C » est la valeur de la capacité des condensateurs C1 et C2.

A titre illustratif, pour une tension Vp égale à 380V avec une fréquence 50Hz, la tension Vm est égale à 150mV.

Selon un autre exemple illustratif, pour une tension Vp égale à 190V avec une fréquence 60Hz, la tension Vm est égale à 62mV.

Au contraire, en l'absence de tension électrique entre les conducteurs électriques 31 et 33, la tension de mesure est nulle.

L'unité 51 est programmée pour mesurer la tension de mesure fournie par le circuit de mesure 84, par exemple en continu ou à des instants répétés au cours du temps, et pour générer un signal d'état correspondant en fonction de la tension de mesure Vm acquise. L'unité 51 envoie alors ce signal d'état à destination du bus de données, par exemple à un instant prédéterminé ou bien en réponse à une requête émise par l'unité centrale 2.

Par exemple, l'unité électronique 51 détermine automatiquement qu'aucune tension électrique n'est présente entre les conducteurs électriques 31 et 33 si la tension mesurée Vm reste durablement nulle, par exemple pendant plus de dix fois la durée de la fréquence du courant électrique d'alimentation, de préférence plus de cent fois. L'unité électronique 51 détermine qu'une tension électrique est présente entre les conducteurs électriques 31 et 33 dans le cas contraire.

Un tel capteur de tension 80 permet de détecter la présence ou, alternativement, l'absence d'une tension électrique et donc d'extrapoler l'état du disjoncteur 10 de l'ensemble 3 auquel appartient le module 30, sans avoir besoin d'avoir besoin d'accéder physiquement au disjoncteur 10. Cette détection est réalisée sans contact électrique direct avec les conducteurs électriques 31, 32 et 33. Il n'est donc pas nécessaire d'équiper le capteur de tension 80 d'une isolation galvanique, qui est plus coûteuse et plus complexe à intégrer. La précision de la mesure n'est pas un obstacle au bon fonctionnement du capteur de tension 80, car on souhaite ici principalement savoir si une tension électrique Vp est présente ou non entre les conducteurs de puissance 31 et 33, et non pas nécessairement obtenir une valeur précise de cette tension électrique.

En variante, le capteur de tension 80 peut être réalisé différemment, par exemple en remplaçant les plaques 81 et 83 par un unique capteur de champ électrique disposé en face d'une des parties centrales 311, 321 ou 331.

Selon une autre variante, le capteur de tension 80 est remplacé par un capteur de tension comportant un pont diviseur directement raccordé aux conducteurs électriques 31, 32 et 33. Dans ce cas, une isolation galvanique est nécessaire.

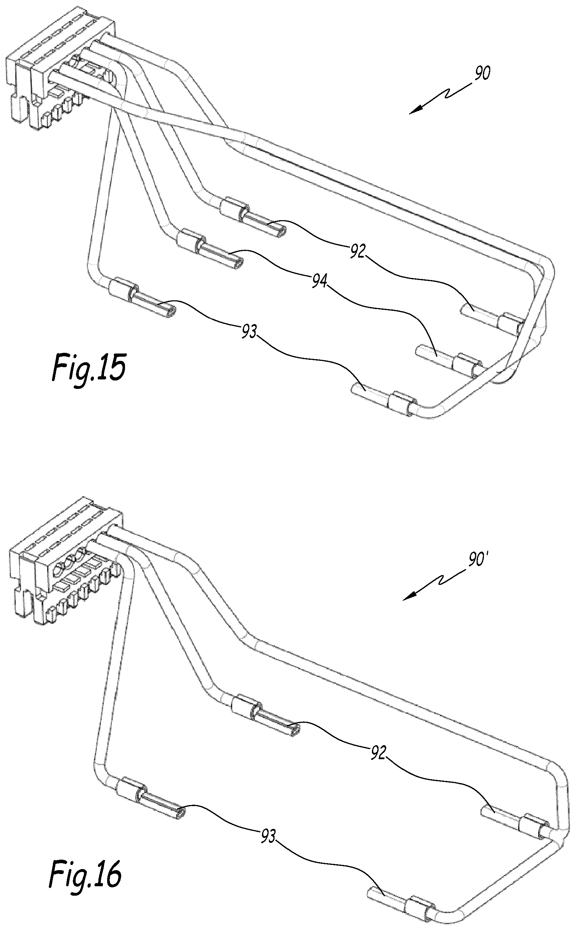

Les figures 15 et 16 représentent la liaison de données 90 entre le module 30 et le contacteur 20. Cette liaison de données 90 est adaptée pour transmettre un signal de commande d'ouverture ou de fermeture du contacteur 20. Cette liaison de données 90 est également adaptée pour collecter un ou plusieurs signaux de mesure de l'état du contacteur 20. Ce dispositif 90 est adapté pour se connecter à une interface d'entrée/sortie de signaux correspondante du contacteur 20.

Plus précisément, la liaison 90 comporte un connecteur 91 et des paires de fils 92, 93 et 94. Le connecteur 91 est adapté pour être connecté à la carte électronique 50. Par exemple, le connecteur 91 est ici fixé à la carte 50, à une des extrémités de cette carte électronique 50.

Avantageusement, la liaison 90 comporte une armature rigide sur laquelle sont montés les paires de fils 92, 93 et 94. Par exemple, cette armature est réalisée en plastique surmoulé sur les paires de fils 92, 93 et 94. Cela facilite le montage du module 30 sur le contacteur 20, notamment en réduisant l'espace occupé par les fils 92, 93 et 94. Cette armature peut être omise.

Le connecteur 91 comporte plusieurs ouvertures chacune destinée à recevoir un des fils des paires de fils 92, 93 ou 94, de manière à les raccorder électriquement à des pistes électriques correspondantes du circuit imprimé de la carte électronique 50.

Par exemple, les fils de la paire de fils 92 sont destinés à alimenter électriquement l'actionneur du contacteur 20. La paire de fils 93 est configurée pour collecter le signal d'état NO depuis une interface de sortie correspondante du contacteur 20. De façon similaire, les fils de la paire de fils 94 sont adaptés pour collecter le signal d'état NC depuis l'interface de sortie correspondante du contacteur 20.

Dans cet exemple, comme illustré à la figure 15, l'un des terminaux associés au fil 92 est commun avec l'un des terminaux associés au fil 93. Ceci est par exemple dû au fait que les signaux correspondants sont générés par rapport à une masse électrique commune au sein du contact électrique 20. En variante, ces deux fils peuvent être distincts l'un de l'autre.

La figure 16 représente un autre mode de réalisation de la liaison 90. Cette liaison de données, notée 90', est similaire à la liaison 90, mais en diffère en ce que la paire de fils 94 est omise. Cela est utile dans les applications pour lesquelles il n'est pas nécessaire de connaître le signal d'état NC.

Le module 30 permet, grâce à l'appareil de mesure 60, au capteur de tension 80 et à l'unité électronique 51, de collecter des informations en temps réel sur l'état de fonctionnement du disjoncteur 10 et du contacteur 20, et de commander ces derniers, en fonction de ces informations et/ou depuis l'unité centrale 2, de façon améliorée.

Grâce à ce module 30, l'ensemble électrique 3 dispose de fonctions avancées de communication et de contrôle, sans qu'il ne soit nécessaire de modifier l'architecture ou le fonctionnement du disjoncteur 10 ou du contacteur 20. Le module 30 permet ainsi d'ajouter de nouvelles fonctionnalités à des gammes de produits existants, voire même à des disjoncteurs 10 et/ou des contacteurs 20 déjà installés sur une installation électrique 1 existante.

Les modes de réalisation et les variantes envisagés ci-dessus peuvent être combinés entre eux pour générer de nouveaux modes de réalisation.

## Revendications

1. Module d'interconnexion (30) entre un disjoncteur électrique (10) et un contacteur électrique (20), ce module d'interconnexion comportant :

   - un boîtier (70),
   - plusieurs conducteurs électriques de puissance (31, 32, 33) logés à l'intérieur du boîtier, chacun des conducteurs électriques de puissance étant adapté pour raccorder électriquement une sortie électrique d'un disjoncteur à une entrée électrique d'un contacteur, afin d'assurer la circulation d'un courant électrique d'alimentation depuis le disjoncteur vers le contacteur,
   - un appareil de mesure du courant (60), adapté pour mesurer des valeurs du courant qui circule au travers des conducteurs électriques de puissance (31, 32, 33), et
   - une unité électronique de traitement (51),

   chaque conducteur électrique de puissance (31, 32, 33) comportant une partie centrale (311, 321, 331) plane, une partie supérieure (312, 322, 332) et une partie inférieure (313, 323, 333), les parties supérieure et inférieure s'étendant en saillie perpendiculairement par rapport à la partie centrale depuis des extrémités opposées de la partie centrale,
l'unité électronique de traitement (51) étant ménagée sur une carte électronique (50),
les conducteurs électriques (31, 32, 33) traversant a carte électronique (50) au moyen d'orifices de passage formés dans la carte électronique (50),
l'appareil de mesure du courant (60) étant fixé sur une face de la carte électronique (50) ;
**caractérisé en ce que**
le module d'interconnexion comporte de plus un capteur de tension électrique (80) pour détecter une tension électrique (Vp) entre au moins deux des conducteurs électriques de puissance (31, 32, 33);
**en ce que** l'unité électronique de traitement (51) est pourvue d'une interface de raccordement à un bus de données (6) et est programmée pour transmettre les valeurs mesurées par l'appareil de mesure vers le bus de données (6), l'unité électronique de traitement (51) étant également raccordée électriquement au capteur de tension (80) et étant programmée pour transmettre un signal vers le bus de données lorsqu'une telle tension électrique (Vp) est détectée par le capteur de tension (80),
et **en ce que** le capteur de tension (80) comporte au moins une plaque électriquement conductrice (81, 83) disposée sur une face opposée de la carte électronique, à distance et en face d'un des conducteurs électriques de puissance (31, 32, 33), en regard d'une plaque (316, 336) formée sur la partie centrale d'un des conducteurs électriques de puissance, la tension électrique (Vp) étant détectée en fonction de la valeur de la capacité électrique (C1, C2) entre la plaque électriquement conductrice et le conducteur électrique de puissance correspondant.

2. Module d'interconnexion selon la revendication 1, **caractérisé en ce que** l'appareil de mesure du courant (60) comprend des capteurs de courant (61, 62, 63) de type Rogowski, chacun monté autour d'un des conducteurs électriques de puissance (31, 32, 33) pour mesurer l'intensité du courant électrique qui circule dans ce conducteur électrique de puissance.

3. Module d'interconnexion selon l'une quelconque des revendications précédentes, **caractérisé en ce qu'**il comporte une liaison de données (90) apte à être raccordée à un circuit de commande du contacteur (20), l'unité électronique de traitement (51) étant en outre programmée pour délivrer un signal de commande à destination du contacteur par l'intermédiaire de cette interface.

4. Module d'interconnexion selon l'une quelconque des revendications précédentes, **caractérisé en ce qu'**il comporte une plaque de séparation (40) logée à l'intérieur du boîtier (70) et comprenant une zone (41) au moins partiellement surmoulée sur les conducteurs électriques de puissance (31, 32, 33).

5. Module d'interconnexion selon la revendication 4, **caractérisé en ce que** la carte électronique (50) est fixée à la plaque de séparation (40).

6. Dispositif électrique, comportant :

    - un contacteur électrique (20), comportant des contacts électriques séparables adaptés pour sélectivement raccorder ou isoler électriquement l'une de l'autre des entrées et des sorties de courant du contacteur en réponse à un signal de commande,
    - un module d'interconnexion (30), comportant des conducteurs électriques de puissance (31, 32, 33) raccordés électriquement aux entrées de courant du contacteur électrique (20) et étant adapté pour raccorder électriquement ce contacteur électrique à un disjoncteur électrique (10),

    **caractérisé en ce que** le module d'interconnexion est selon l'une quelconque des revendications précédentes, les conducteurs électriques de puissance (31, 32, 33) du module d'interconnexion étant raccordés électriquement aux entrées de courant du contacteur.

7. Dispositif électrique selon la revendication 6, **caractérisé en ce que** le module d'interconnexion (30) est selon la revendication 3 et **en ce que** la liaison de données (90) est connectée à une interface correspondante du contacteur électrique (20) pour commuter le déplacement des contacts séparables du contacteur entre des états ouvert et fermé.

8. Ensemble électrique, comportant :

    - un disjoncteur électrique (10),
    - un dispositif électrique, comportant un contacteur électrique (20) et un module d'interconnexion (30) raccordé au contacteur,

    dans lequel le module d'interconnexion (30) est agencé entre le disjoncteur et le contacteur, et raccordant électriquement le disjoncteur au contacteur, **caractérisé en ce que** le dispositif électrique est conforme à l'une quelconque des revendications 6 et 7.

**Patentansprüche**

1. Verbindungsmodul (30) zwischen einem elektrischen Ausschalter (10) und einem elektrischen Kontaktschalter (20), wobei dieses Verbindungsmodul Folgendes umfasst:

- ein Gehäuse (70),
- mehrere elektrische Leistungsleiter (31, 32, 33), die im Inneren des Gehäuses aufgenommen sind, wobei jeder der elektrischen Leistungsleiter dafür eingerichtet ist, einen elektrischen Ausgang eines Ausschalters mit einem elektrischen Eingang eines Kontaktschalters elektrisch zu verbinden, um das Fließen eines elektrischen Speisestroms von dem Ausschalter zu dem Kontaktschalter sicherzustellen,
- eine Strommessvorrichtung (60), die dafür eingerichtet ist, Werte des Stroms zu messen, der durch die elektrischen Leistungsleiter (31, 32, 33) fließt, und
- eine elektronische Verarbeitungseinheit (51),

wobei jeder elektrische Leistungsleiter (31, 32, 33) einen ebenen mittleren Teil (311, 321, 331), einen oberen Teil (312, 322, 332) und einen unteren Teil (313, 323, 333) umfasst, wobei der obere und untere Teil sich ausgehend von den entgegengesetzten Enden des mittleren Teils senkrecht in Bezug auf den mittleren Teil vorspringend erstrecken, wobei die elektronische Verarbeitungseinheit (51) auf einer Elektronikkarte (50) ausgebildet ist, wobei die elektrischen Leiter (31, 32, 33) die Elektronikkarte (50) mithilfe von Durchgangsöffnungen durchqueren, die in der Elektronikkarte (50) gebildet sind, wobei die Strommessvorrichtung (60) auf einer Fläche der Elektronikkarte (50) befestigt ist; **dadurch gekennzeichnet,** **dass** das Verbindungsmodul darüber hinaus einen Sensor für elektrische Spannung (80) umfasst, um eine elektrische Spannung (Vp) zwischen wenigstens zwei der elektrischen Leistungsleiter (31, 32, 33) zu detektieren; **dass** die elektronische Verarbeitungseinheit (51) mit einer Schnittstelle zur Verbindung mit einem Datenbus (6) versehen ist und dafür programmiert ist, die durch die Messvorrichtung gemessenen Werte zu dem Datenbus (6) zu übertragen, wobei die elektronische Verarbeitungseinheit (51) auch mit dem Spannungssensor (80) elektrisch verbunden ist und dafür programmiert ist, ein Signal zu dem Datenbus zu übertragen, wenn eine solche elektrische Spannung (Vp) durch den Spannungssensor (80) detektiert wird, und **dass** der Spannungssensor (80) wenigstens eine elektrisch leitende Platte (81, 83) umfasst, die auf einer gegenüberliegenden Fläche der Elektronikkarte, von einem der elektrischen Leistungsleiter (31, 35 32, 33) beabstandet und diesem zugewandt und gegenüber einer Platte (316, 336) angeordnet ist, die auf dem mittleren Teil von einem der elektrischen Leistungsleiter gebildet ist, wobei die elektrische Spannung (Vp) als Funktion des Werts der elektrischen Kapazität (C1, C2) zwischen der elektrisch leitenden Platte und dem entsprechenden elektrischen Leistungsleiter detektiert wird.

2. Verbindungsmodul nach Anspruch 1, **dadurch gekennzeichnet, dass** die Strommessvorrichtung (60) Stromsensoren (61, 62, 63) vom Typ Rogowski umfasst, die jeweils um einen der elektrischen Leistungsleiter (31, 32, 33) montiert sind, um die Stärke des elektrischen Stroms zu messen, der in diesem elektrischen Leistungsleiter fließt.

3. Verbindungsmodul nach einem der vorhergehenden Ansprüche, **dadurch gekennzeichnet, dass** er einen Datenanschluss (90) umfasst, der mit einer Steuerschaltung des Kontaktschalters (20) verbunden werden kann, wobei die elektronische Verarbeitungseinheit (51) ferner dafür programmiert ist, über diese Schnittstelle ein an den Kontaktschalter gerichtetes Steuersignal auszugeben.

4. Verbindungsmodul nach einem der vorhergehenden Ansprüche, **dadurch gekennzeichnet, dass** es eine Trennplatte (40) umfasst, die im Inneren des Gehäuses (70) aufgenommen ist und einen Bereich (41) umfasst, der wenigstens teilweise über die elektrischen Leistungsleiter (31, 32, 33) überformt ist.

5. Verbindungsmodul nach Anspruch 4, **dadurch gekennzeichnet, dass** die Elektronikkarte (50) an der Trennplatte (40) befestigt ist.

6. Elektrische Vorrichtung, umfassend:

- einen elektrischen Kontaktschalter (20), der trennbare elektrische Kontakte umfasst, die dafür eingerichtet sind, Stromeingänge und -ausgänge des Kontaktschalters als Reaktion auf ein Steuersignal selektiv elektrisch miteinander zu verbinden oder voneinander zu isolieren,
- ein Verbindungsmodul (30), das elektrische Leistungsleiter (31, 32, 33) umfasst, die mit den Stromeingängen des elektrischen Kontaktschalters (20) elektrisch verbunden sind, und das dafür eingerichtet ist, diesen elektrischen Kontaktschalter mit einem elektrischen Ausschalter (10) elektrisch zu verbinden,

**dadurch gekennzeichnet, dass** das Verbindungsmodul ein solches nach einem der vorhergehenden Ansprüche ist, wobei die elektrischen Leistungsleiter (31, 32, 33) des Verbindungsmoduls mit den Stromeingängen des Kontaktschalters elektrisch verbunden sind.

**7.** Elektrische Vorrichtung nach Anspruch 6, **dadurch gekennzeichnet, dass** das Verbindungsmodul (30) ein solches nach Anspruch 3 ist und dass der Datenanschluss (90) mit einer entsprechenden Schnittstelle des elektrischen Kontaktschalters (20) verbunden ist, um die Bewegung der trennbaren Kontakte des Kontaktschalters zwischen einem offenen und einem geschlossenen Zustand umzuschalten.

**8.** Elektrische Baugruppe, umfassend:

- einen elektrischen Ausschalter (10),
- eine elektrische Vorrichtung, umfassend einen elektrischen Kontaktschalter (20) und ein Verbindungsmodul (30), das mit dem Kontaktschalter verbunden ist,

wobei das Verbindungsmodul (30) zwischen dem Ausschalter und dem Kontaktschalter angeordnet ist und den Ausschalter elektrisch mit dem Kontaktschalter verbindet,
**dadurch gekennzeichnet, dass** die elektrische Vorrichtung einem der Ansprüche 6 und 7 entspricht.

**Claims**

**1.** Interconnect module (30) between an electrical circuit breaker (10) and an electrical contactor (20), the interconnect module comprising:

- a housing (70),
- a plurality of electrical power conductors (31, 32, 33) housed inside the housing, each of the electrical power conductors being adapted to electrically connect an electrical output of a circuit breaker to an electrical input of a contactor in order to ensure the flow of an electrical supply current from the circuit breaker to the contactor,
- a current-measuring apparatus (60) adapted to measure values of the current flowing through the electrical power conductors (31, 32, 33), and
- an electronic processing unit (51),

each electrical power conductor (31, 32, 33) comprising a flat central portion (311, 321, 331), an upper portion (312, 322, 332) and a lower portion (313, 323, 333), the upper and lower portions projecting perpendicularly relative to the central portion from opposite ends of the central portion,
the electronic processing unit (51) being formed on an electronic board (50),
the electrical conductors (31, 32, 33) passing through the electronic board (50) by means of through-holes formed in the electronic board (50),
the current-measuring apparatus (60) being fixed to a face of the electronic board (50);
**characterised in that**

the interconnect module further comprises an electrical voltage sensor (80) for detecting an electrical voltage (Vp) between at least two of the electrical power conductors (31, 32, 33),
**in that** the electronic processing unit (51) is provided with an interface for connection to a data bus (6) and is programmed to transmit the values measured by the measuring apparatus to the data bus (6), the electronic processing unit (51) also being electrically connected to the voltage sensor (80) and being programmed to transmit a signal to the data bus when such an electrical voltage (Vp) is detected by the voltage sensor (80),
and **in that** the voltage sensor (80) comprises at least one electrically conductive plate (81, 83) arranged on an opposite face of the electronic board, at a distance from and facing one of the electrical power conductors (31, 32, 33), opposite a plate (316, 336) formed on the central portion of one of the electrical power conductors, the electrical voltage (Vp) being detected as a function of the value of the electrical capacitance (C1, C2) between the electrically conductive plate and the corresponding electrical power conductor.

**2.** Interconnect module according to claim 1, **characterised in that** the current-measuring apparatus (60) comprises current sensors (61, 62, 63) of the Rogowski type each mounted around one of the electrical power conductors (31, 32, 33) in order to measure the intensity of the electric current flowing **in that** electrical power conductor.

**3.** Interconnect module according to any one of the preceding claims, **characterised in that** it comprises a data link (90) which is capable of being connected to a control circuit of the contactor (20), the electronic processing unit (51) further being programmed to deliver a control signal to the contactor by way of that interface.

**4.** Interconnect module according to any one of the preceding claims, **characterised in that** it comprises a separation plate (40) housed inside the housing (70) and comprising a zone (41) that is at least partially overmoulded on the electrical power conductors (31, 32, 33).

**5.** Interconnect module according to claim 4, **characterised in that** the electronic board (50) is fixed to the separation plate (40).

**6.** Electrical device, comprising:

- an electrical contactor (20) comprising separable electrical contacts which are adapted to selectively connect or isolate electrically from one another current inputs and outputs of the contactor in response to a control signal,
- an interconnect module (30) comprising electrical power conductors (31, 32, 33), which are electrically connected to the current inputs of the electrical contactor (20), and being adapted to electrically connect the electrical contactor to an electrical circuit breaker (10),

**characterised in that** the interconnect module is in accordance with any one of the preceding claims, the electrical power conductors (31, 32, 33) of the interconnect module being electrically connected to the current inputs of the contactor.

7. Electrical device according to claim 6, **characterised in that** the interconnect module (30) is in accordance with claim 3, and **in that** the data link (90) is connected to a corresponding interface of the electrical contactor (20) in order to switch the displacement of the separable contacts of the contactor between open and closed states.

8. Electrical assembly, comprising:

- an electrical circuit breaker (10),
- an electrical device comprising an electrical contactor (20) and an interconnect module (30) connected to the contactor,

wherein the interconnect module (30) is arranged between the circuit breaker and the contactor, and electrically connecting the circuit breaker to the contactor, **characterised in that** the electrical device is in accordance with either claim 6 or claim 7.

Fig.1

Fig.2

*Fig.3*

*Fig.4*

Fig.5

Fig.6

Fig.7

Fig.8

Fig.9

*Fig.10*

*Fig.11*

*Fig.12*

*Fig.13*

*Fig.14*

Fig.15

Fig.16

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2806525 A1
- US 20110119507 A1
- DE 10023966 C1
- US 2004246661 A1
- US 2013229192 A1